Europäisches Patentamt

European Patent Office

Office européen des brevets

(19)

(11) Veröffentlichungsnummer: **0 443 295 A1**

# (12) EUROPÄISCHE PATENTANMELDUNG

(21) Anmeldenummer: 90810974.7

(22) Anmeldetag: 12.12.90

(51) Int. Cl.⁵: **B25J 15/02**, B25J 15/00,
B25J 15/10, B25J 21/00,
H01L 21/00

(30) Priorität: 23.02.90 CH 586/90

(43) Veröffentlichungstag der Anmeldung:
28.08.91 Patentblatt 91/35

(84) Benannte Vertragsstaaten:
BE CH DE ES FR GB LI NL SE

(71) Anmelder: GEBRÜDER SULZER
AKTIENGESELLSCHAFT
Zürcherstrasse 9
CH-8401 Winterthur(CH)

(72) Erfinder: Huguenin, Christian
Bahnhofstrasse 8a
CH-8353 Elgg(CH)
Erfinder: Meyer, Manfred
Grenzstrasse 40
CH-8406 Winterthur(CH)

(54) Werkzeug zum Greifen, Roboter mit einem derartigen Werkzeug sowie Verwendung des Roboters mit dem Greiferwerkzeug.

(57) Das Werkzeug (1) zum Greifen und Bewegen von vorzugsweise pattenartigen Gegenständen (15) verfügt über starre und bewegbare Greifer (14, 14' bzw. 12, 12'). Der Antrieb für die bewegbaren Greifer (12, 12') erfolgt weitgehend mit Schwerkraft, d.h. durch die Lage des Werkzeugs (1) mit den Greifern (12, 12' 14, 14') im Schwerefeld. Die Gegenstände (15) werden nach einem bestimmten Bewegungsablauf mit dem Werkzeug (1) im Zusammenwirken mit dem zu fassenden Gegenstand (15) und der Lagerung der Gegenstände gefasst und wieder losgelassen. Das Werkzeug (1) ist dadurch, dass es keinen direkten, aktiven, motorischen Antrieb aufweist, für die Verwendung mit Robotern, besonders auch in Reinräumen, geeignet.

Fig.1A

EP 0 443 295 A1

Die Erfindung bezieht sich auf ein Werkzeug zum Greifen und Bewegen von Gegenständen, einen Roboter mit einem derartigen Werkzeug, sowie die Verwendung des Roboters mit dem Werkzeug.

Werkzeuge mit Greifern, die zum Fassen und Bewegen irgendwelcher Gegenstände verwendet werden, arbeiten mit Antrieben, deren Wirkung beispielweise direkt oder über Hebelsysteme auf die Greifer übertragen werden. Der Antrieb kann z.B. elektrisch, magnetisch, hydraulisch oder pneumatisch erfolgen. Diese Werkzeuge können insbesondere beim Verwenden mit Robotern oder anderen Manipulatoren technisch aufwendige Steuerungen oder gar Regelungen, etwa mit Lastbegrenzern, verlangen. Dies ist insbesondere dann der Fall, wenn es sich bei den zu handhabenden/manipulierenden/(Handling) Gegenständen z.B. um fragile, zerbrechliche oder wenig formstabile Körper wie Glas-, Metall- oder Kunststoffplatten handelt.

Solche Antriebe für die Greifer können immer Quellen von Verschmutzung sein, die beispielsweise in Reinräumen stören können. Auf jeden Fall sind meist besondere bauliche Massnahmen, wie Absaugungen usw. vorzusehen, um der Verschmutzung, insbesondere durch die Antriebselemente, entgegenzuwirken.

Es geht also darum, ein Greiferwerkzeug mit möglichst geringem konstruktivem Aufwand zu schaffen, das u.a. auch mit Robotern und Manipulatoren einwandfrei funktioniert und es erlaubt, empfindliche und/oder wenig formstabile Gegenstände zu fassen und zu bewegen.

Nach der Erfindung weist ein derartiges Werkzeug zum Greifen die Merkmale des ersten Anspruchs auf. Weiter sind ein Roboter mit einem derartigen Werkzeug und seine Verwendung in einer Produktionslinie für elektrische bzw. elektronische Bauteile Gegenstand der Erfindung. Die abhängigen Ansprüche beziehen sich auf besondere Ausführungsarten der Erfindung.

Die vorliegende Erfindung schafft ein Werkzeug, das es auf einfache Weise erlaubt, fragile und/oder wenig formstabile Gegenstände zu erfassen und zu manipulieren, wobei diese Eigenschaften beim Verwenden mit einem Roboter oder anderen Manipulatoren besonders ausgeprägt zur Geltung kommen. Roboter und Manipulatoren erlauben es, Greiferwerkzeuge mit schwerkraftbetätigbaren Greifern durch Bewegungen des ganzen Werkzeugs und im Zusammenwirken mit dem zu greifenden/manipulierenden Gegenstand zu betätigen. Damit entfallen aufwendige Steuer- und Regelelemente für das Betätigen der Greifer des Greiferwerkzeugs. Dies wiederum kann auch zum Erhöhen der zulässigen Nutzlast für eine Robotereinrichtung führen.

Die schwerkraftbewegbaren Greifer können auch Federelemente aufweisen, welche z.B. den durch die Schwerkraft verursachten Bewegungen des Greifers entgegenwirken oder diese Bewegungen unterstützen. Die Hilfs-Federelemente können so ausgeführt sein, dass sie nur in einem begrenzten Lagebereich der Greifer wirksam sind, beispielsweise um Reibung, z.B. Haftreibung zu überwinden, was die Zuverlässigkeit des Werkzeugs verbessert.

Der Schwerkraft entgegenwirkende Federelemente können dazu beitragen, den Einsatzbereich von Werkzeugen bestimmter Bauweise zu erweitern, indem z.B. die Greifkräfte der Greifer vermindert werden, was es ermöglicht, fragilere zu bewegende Gegenstände schonender zu behandeln. Der Schwerkraft entgegenwirkende Federelemente erweitern aber auch die konstruktiven Möglichkeiten für Greifer, indem der Massenbereich/Gewichtsbereich der Greifer durch diese einfachen Massnahmen erweitert werden kann.

Das Werkzeug zum Greifen und Bewegen von vorzugsweise plattenartigen Gegenständen, verfügt über starre und bewegbare Greifer. Der Antrieb für die bewegbaren Greifer erfolgt weitgehend mit Schwerkraft, d.h. durch die Lage des werkzeugs mit den Greifern im Schwerefeld. Die Gegenstände werden nach einem bestimmten Bewegungsablauf mit dem Werkzeug im Zusammenwirken mit dem zu fassenden Gegenstand und der Lagerung der Gegenstände gefasst und wieder losgelassen. Das Werkzeug ist dadurch, dass es keinen direkten, aktiven, motorischen Antrieb aufweist, für die Verwendung mit Robotern, besonders auch in Reinräumen, geeignet.

Die Erfindung wird nachstehend anhand von schematischen Zeichnungen, die Ausführungsbeispiele und Einzelheiten davon zeigen, näher erläutert.

Es zeigen:

Fig. 1A
Schematisch, in einer Aufsicht ein rahmenartiges Greiferwerkzeug mit je einem starren und einem bewegbaren Greiferpaar;

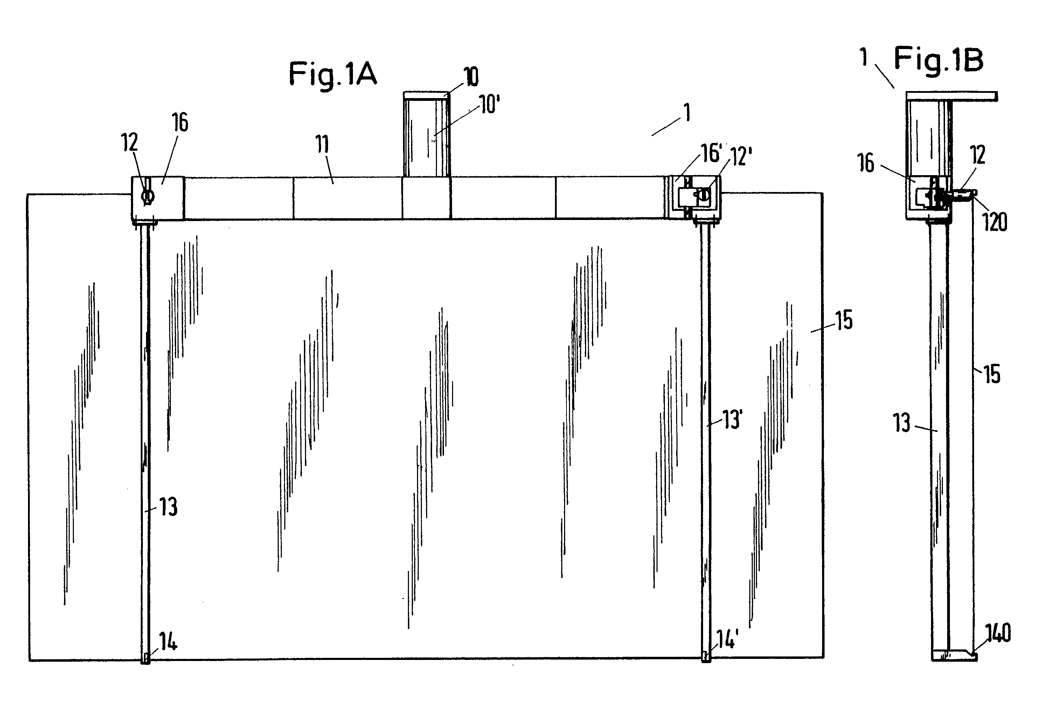

Fig. 1B
das Greiferwerkzeug von Fig. 1A in einer schematischen Seitenansicht;

Fig. 2
die Ansicht eines Teil des Rahmens eines Greiferwerkzeugs mit zwei bewegbaren Greifern am Halbarm;

Fig. 3A bis 3D
in einer schematischen Seitenansicht ein Greiferwerkzeug, wobei verschiedene verschiedene Momente des Greifens einer Platte gezeigt und erklärt werden;

Fig. 4A und 4B
in einer schematischen Seitenansicht ein Greiferwerkzeug mit federunterstütztem bewegbarem Greifer;

Fig. 5

schematisch einen Roboter mit einem Greiferwerkzeug beim Entladen bzw. Beladen eines Transportwagens mit plattenförmigen Gegenständen.

Das in den Fig. 1A und 1B gezeigte, rahmenartige Greiferwerkzeug 1 wird vom prismatisch ausgebildeten Querträger 11 mit den beiden bewegbaren Greifern 12, 12' sowie den beiden Schenkeln 13, 13' mit den beiden starren Greifern 14, 14' gebildet. Mit dem Flansch 10 am Fortsatz 10' des Querträgers 11 kann das Greiferwerkzeug 1 an einem hier nicht gezeigten Manipulator oder dem Arm eines Roboters befestigt werden.

Die starren und die bewegbaren Greifer, 14, 14' bzw. 12, 12' sind einander gegenüberliegend angeordnet und zwischen ihnen ist ein plattenartiger Gegenstand 15 in den Nuten 120, 140 festgehalten. In Schräglage oder in senkrechter Lage des Greiferwerkzeugs 1 genügt die Schwerkraft der geführten Greifer 12, 12', um die Platte 15 festzuhalten. Das Greiferwerkzeug 1 ist also vom Roboterarm bzw. Manipulator vorzugsweise in senkrechter oder schiefer Lage zu halten. Beim gezeigten Beispiel sollten die beiden bewegbaren Greifer 12, 12' nicht unterhalb der starren Greifer 14, 14' liegen, solange die Platte 15 zu halten ist. Es sind allerdings auch Werkzeuge denkbar, bei denen die Schwerkraftbetätigung von Greifern z.B. über Hebel erfolgt, die so angeordnet sind, dass irgendeine andere Lage des Werkzeugs beim Greifen vermieden werden sollte.

Die bewegbaren Greifer 12 und 12' sind in den Kammern 16, 16' des prismatischen Querträgers geführt und ragen durch Öffnungen aus der Wand dieser Kammern 16, 16'. Jede dieser Kammern 16, 16' kann einen Stutzen (nicht gezeichnet) aufweisen, durch den z.B. Luft in die Kammern 16, 16' eingeblasen oder daraus abgesaugt werden kann. Beim Einsatz des Werkzeugs werden durch Absaugen seine Reinraumeigenschaften verbessert. Sowohl beim Blasen als auch beim Saugen kann der bewegliche Greifer gekühlt werden, was beim Arbeiten mit heissen Gegenständen von Vorteil sein kann. Selbstverständlich könnten auch die starren Greifer in gleicher Weise gekühlt sein.

In Fig. 2 ist die eine Hälfte einer anderen Ausführung eines Querträgers 2 gezeigt, bei dem jeder Arm zwei in Kammern 26, 26' angeordnete bewegliche Greifer 22, 22' aufweist. Der ganze Querträger 2 hält die Platte 25 mit vier bewegbaren Greifern (nur zwei sind gezeigt) fest.

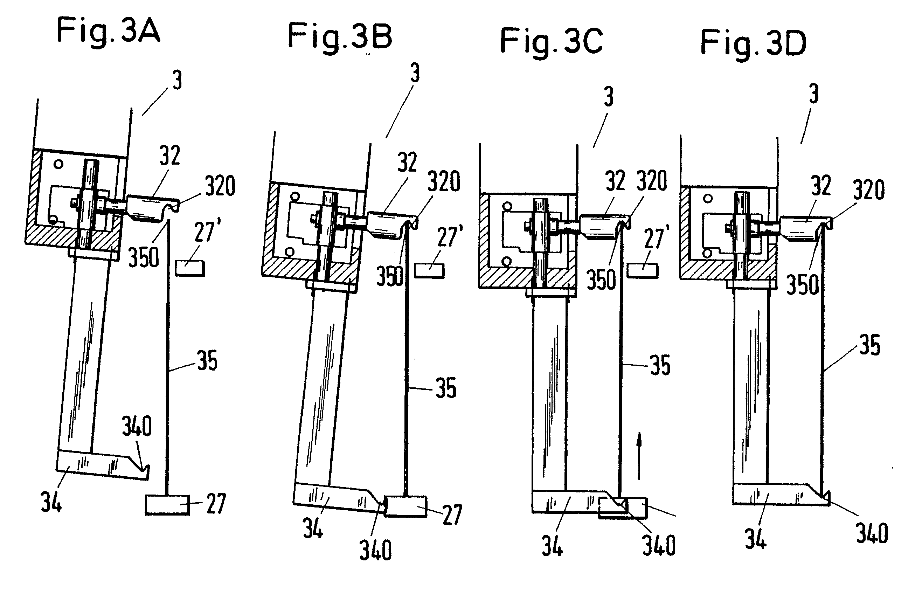

Anhand der Fig. 3A bis 3B wird das Erfassen bzw. Ergreifen und Entladen des Greiferwerkzeugs 3 eines plattenartigen Körpers 35 und damit die Funktionsweise des Greiferwerkzeugs 3 erklärt. Die nachstehend beschriebenen Bewegungen des Greiferwerkzeugs 3 sind so zu verstehen, dass der Manipulator oder Arm des Roboters, an dem das Greiferwerkzeug 3 angeflanscht ist, sich so bewegt, dass das Werkzeug die beschriebenen Bewegungen ausführt. Das Greiferwerkzeug nähert sich dem oberen Rand der Platte 35, die senkrecht oder schräg auf und mit den Lagernocken 27, 27' gelagert und gestützt ist, gegenüber der Platte 35 geneigt, mit den beweglichen Greifern 32 (nur einer gezeigt) seitlich von oben, wie dies Fig. 3A zeigt. Darauf wird das Greiferwerkzeug 3 so abgesenkt, dass der obere Rand 350 der Platte 35 in die Nuten 320 gelangt und die Greifer 32 geführt nach oben ausgelenkt werden, wie dies in Fig. 3B dargestellt ist. Dann wird das Greiferwerkzeug 3 um die Berührungsbereiche von Nute 320 und oberem Rand 350 der Platte 35 in eine in Fig. 3C gezeigte Lage geschwenkt, so dass die Nuten 340 der starren Greifer 34 (nur einer gezeichnet) unter den unteren Rand 350' der Platte 35 zu liegen kommt. Beim Anheben des Greiferwerkzeugs 3 in Richtung der Platte 35 (Pfeil), senken sich die bewegbaren Greifer 32 unter der Einwirkung der Schwerkraft ab und bleiben in Kontakt mit der oberen Kante 350 der Platte 35, wie dies in Fig. 3D dargestellt ist, wo die Platte 35, schon von den Lagernocken 27, 27' abgehoben, dargestellt ist. Das Entladen der Platte 35 vom Greiferwerkzeug 3 kann in umgekehrter Reihenfolge der Bewegungen nach den Fig. 3D bis 3A erfolgen.

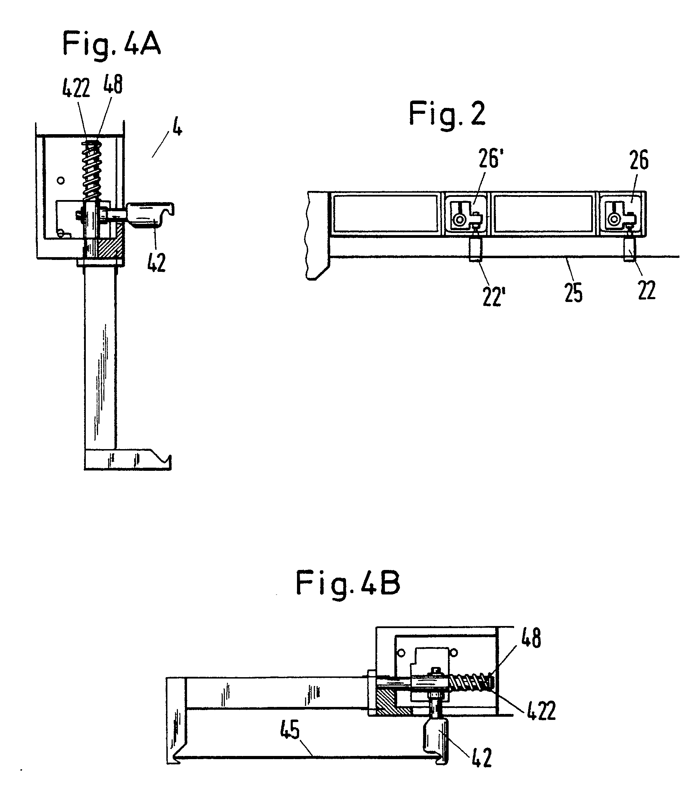

Der bewegliche Greifer 42 des Greiferwerkzeugs 4 von Fig. 4A weist eine Feder 48 als Hilfsfedermittel auf. Ist der bewegbare Greifer 42 an der Feder 48 aufgehängt, wirkt die Feder 42 als Rückhaltefeder, die gegen die Schwerkraft wirkt und somit den bewegbaren Greifer entlastet, d.h. die Belastung des zu greifenden Gegenstandes verringert. Wirkt die Feder 42 als Rückstellfeder in Richtung der Schwerkraft, kann diese z.B. dazu dienen, Haftreibung des bewegbaren Greifers 42 auf der Führung 422 zu überwinden oder eine Platte 45 noch bei starker Neigung des Greiferwerkzeugs 4 sicher zu halten, möglicherweise in eine horizontale Lage zu legen, wie dies in Fig. 4B gezeigt ist, und freizugeben. Die Feder 48 könnte auch so ausgebildet sein, dass sie in einem bestimmten Auslenkbereich des bewegbaren Greifers 42 als Rückstellfeder in Richtung der Schwerkraft und in einem anderen als Rückstellfeder gegen die Richtung der Schwerkraft wirkt.

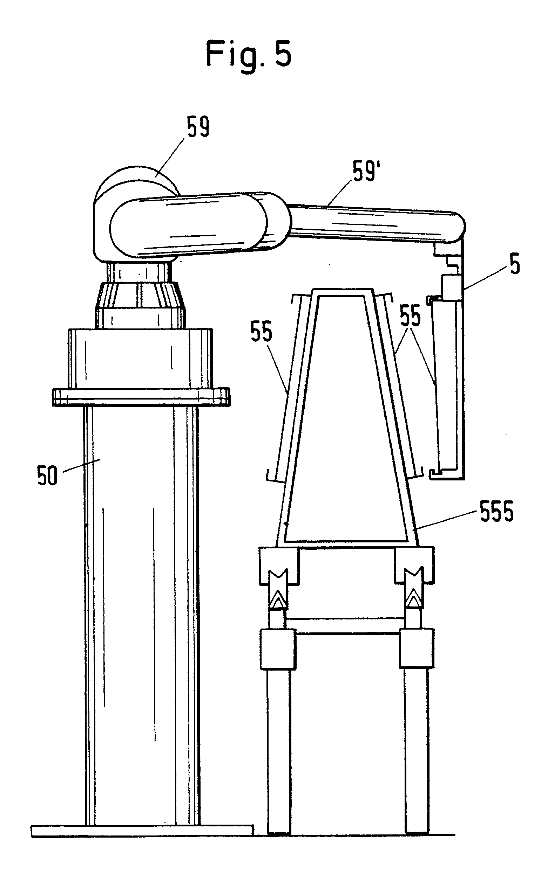

Fig. 5 schliesslich zeigt den Roboter 59, an dessen Arm 59' das Greiferwerkzeug 5 angeflanscht aufgehängt ist. Der Roboter ist hier auf einem Sockel 50 montiert. Auf dem Schienen-Transportwagen mit dem Lagergestell 555 sind Platten 55, gegenüber der Vertikalen leicht geneigt, gelagert. Die Arbeit des Roboters 59 mit dem Greiferwerkzeug 5 kann nun darin bestehen, die Platten 55 auf das Lagergestell 555 zu laden und/oder von diesem zu entladen. Dies könnte beispielsweise in der mit den Fig. 3A bis 3D geschilderten Weise geschehen.

Der Roboter 59 könnte natürlich auch auf dem Boden oder sogar im Boden versenkt oder an einer Wand befestigt angeordnet sein. Es wäre bei diesen Anordnungen möglicherweise ein Greiferwerkzeug nach der Erfindung zu verwenden, bei dem bewegliche und starre Greifer vertauscht angebracht, d.h. die beweglichen Greifer an den Schenkeln montiert sind. In diesem Fall wäre das Greiferwerkzeug, vom Roboterarm 59 aus betrachtet, nach oben gerichtet zu verwenden. Es ist auch möglich z.B. den Flansch für das Befestigen des Greiferwerkzeugs am Roboterarm 59' an einem der Schenkel 13, 13' (Fig. 1A) anzubringen.

Obschon die gezeigten Beispiele Greiferwerkzeuge mit gleicher Zahl von starren und bewegbaren und jeweils mehreren Greifern zeigen, umfasst die Erfindung selbstverständlich auch Greiferwerkzeuge mit einem einzigen Greifer der einen oder anderen Art. Genauso ist es möglich "schwerkraftgetriebene" Greiferwerkzeuge nach der Erfindung zu bauen, die sich zum Fassen anderer als plattenartiger, z.B. balkenförmige, zylindrische, kugelförmige Gegenstände eignen, wobei mit Vorteil die Form der Greifbereiche der Greifer der Form der zu greifenden Gegenstände anzupassen ist. Es liegt im Bereich des selbstverständlichen Könnens und Ermessens des Fachmanns, Greifer, deren Anordnung und Anzahl den Erfordernissen des zu greifenden und zu bewegenden Gegenstandes anzupassen. Greiferwerkzeuge der für Platten geeigneten, beschriebenen Art können z.B. in Reinräumen bei der Herstellung von LCD (Liquid Crystal Display), photoelektrischen Zellen, Halbleiterkomponenten, oder Halbfabrikaten davon eingesetzt werden.

## Patentansprüche

1.  Werkzeug (1) zum Greifen und Bewegen von vorzugsweise plattenartigen Gegenständen (15), mit mindestens einem bewegbaren Greifer (12, 12'), der weitgehend durch die Schwerkraft in seine Greiflage gebracht wird.

2.  Rahmenartig ausgebildetes Werkzeug (1) nach Anspruch 1 mit mindestens einem auf einer Seite des Rahmens 11, 13, 13' angeordneten starren Greifer (14, 14') und mindesten einem, dem starren Greifer (14, 14') gegenüberliegend angeordneten, bewegbaren Greifer (12, 12').

3.  Werkzeug (1) nach Anspruch 1 oder 2 mit nutenartig ausgebildeten Greifbereichen (120, 140) der Greifer.

4.  Werkzeug (1) nach einem der Ansprüche 1 bis 3 mit einem starren Greiferpaar (14. 14') und einem diesem gegenüberliegend angeordneten bewegbaren Greiferpaar (12, 12').

5.  Werkzeug (4) nach einem der Ansprüche 1 bis 4, mit Hilfsfedermitteln (48) zum Rückstellen mindestens des einen bewegbaren Greifers (42) in die Greiflage.

6.  Werkzeug (4) nach einem der Ansprüche 1 bis 4 mit Hifsfedermitteln (48), die gegen die von der Schwerkraft verursachten Bewegungen mindestens des einen bewegbaren Greifers (42) wirken.

7.  Werkzeug (1) nach einem der Ansprüche 1 bis 6, bei dem wenigstens der eine bewegbare Greifer (12, 12') aus einem Gehäuse (16, 16') herausragt, an welchem eine Saug- oder Blaseinrichtung angeschlossen ist.

8.  Roboter (59) mit einem Greiferwerkzeug (5) nach einem der Ansprüche 1 bis 7.

9.  Verwendung eines Roboters (59) mit Greifwerkzeug (5) nach Anspruch 8 zum Greifen und Bewegen von Gegenständen in einer Produktionslinie für elektrische und/oder elektronische Bauteile (55) oder Halbfabrikaten (55) davon.

10. Verwendung eines Roboters (59) mit Greiferwerkzeug (55) nach Anspruch 8 oder 9 in einer Reinraumproduktionslinie.

Fig.1B

Fig.1A

# Fig. 3A

3

32

320

27'

350

35

340

34

27

# Fig. 3B

3

32

320

27'

350

35

34

340

27

# Fig. 3C

3

32 320

350

35

34

340

# Fig. 3D

3

32 320

350

35

34

340

EP 0 443 295 A1

Fig. 4A

422   48

4

42

Fig. 2

26'                26

22'        25        22

Fig. 4B

48

422

45        42

7

# Fig. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
| --- | --- | --- | --- |
| Y | EP-A-0 163 065 (I.B.M.)<br>* Zusammenfassung * * Seite 4, Zeile 28 - Zeile 33 *<br>— — — | 1-3,5,6,8 | B 25 J 15/02<br>B 25 J 15/00<br>B 25 J 15/10 |
| Y,A | DE-A-3 516 853 (DAINIPPON SCREEN MANUFACTUR-ING)<br>* Seite 17, Zeile 3 - Zeile 12 *<br>— — — | 1-3,5,6,8,4 | B 25 J 21/00<br>H 01 L 21/00 |
| A | GB-A-9 314 90 (ATKRON)<br>* Seite 6, Zeile 83 - Zeile 109; Abbildung 10 *<br>— — — | 1-3,5,6 | |
| A | US-A-4 410 209 (TRAPANI)<br>* Spalte 3, Zeile 23 - Zeile 68; Abbildungen 1-3 *<br>— — — | 2-5 | |
| A | I.B.M.TECHNICAL DISCLOSURE BULLETIN Bd. 22, Nr. 1, Juni 1979, ARMONK NY US Seiten 120 - 121; HANSEN: 'convertible wafer size gripper assembly '<br>* das ganze Dokument *<br>— — — | 4,9 | |
| A | EP-A-0 272 205 (SULZER)<br>* Ansprüche 1,16,18 *<br>— — — — — | 7,10 | |

| RECHERCHIERTE SACHGEBIETE (Int. Cl.5) |
| --- |
| B 25 J<br>H 01 L |

Der vorliegende Recherchenbericht wurde für alle Patentansprüche erstellt

| Recherchenort | Abschlußdatum der Recherche | Prüfer |
| --- | --- | --- |
| Den Haag | 17 Mai 91 | LAMMINEUR P.C.G. |